# DEMANDE DE BREVET EUROPEEN

(11) **EP 2 492 970 A1**
(43) Date de publication de la demande: **29.08.2012**
(21) Numéro de dépôt: 12156583.2
(22) Date de dépôt: 22.02.2012
(51) Int. Cl.: H01L 31/06, H01L 31/042

(54) **Cellule photovoltaïque rectangulaire**

(30) Priorité: 25.02.2011 FR 1100583
(71) Demandeur: MPO Energy, 53700 Averton (FR)
(72) Inventeur: Bechevet, Bernard, 74420 HABERE POCHE (FR); Jourdan, Johann, 73000 Chambéry (FR); de Magnienville, Sylvin, 53370 Saint Pierre des Nids (FR)
(74) Mandataire: Vigand, Philippe

(57) **Abrégé**

Cellule photovoltaïque (100) comprenant au moins une plaque (10) en matériau actif photovoltaïque de forme rectangulaire avec une largeur et une longueur, la plaque comportant deux faces principales (12, 15), au moins un collecteur conducteur de l'électricité (20) étant agencé sur chaque face, dans le sens de la largeur de la plaque, **caractérisée en ce que** la largeur de la plaque est supérieure à 151 mm et en ce que la longueur de la plaque (10) est le double de la largeur.

## Description

La présente invention concerne de manière générale une cellule photovoltaïque destinée à être montée sur un panneau solaire.

Il est connu dans l'art antérieur des cellules photovoltaïques en silicium mono ou poly-cristallin. Ces cellules sont de forme carrée dont le côté varie entre 100 et 200 millimètres. Pour réduire la surface entre cellules perdue lors de leur assemblage en panneau solaire, les cellules voient leur taille augmenter. En contrepartie, cette augmentation de taille présente plusieurs inconvénients et notamment d'une part de devoir sans cesse adapter les outils de fabrication aux nouvelles dimensions de la cellule et d'autre part d'augmenter les pertes par dissipation thermique dues à l'effet joule lors de la collecte du courant à la surface de la cellule car le circuit électrique est plus long. Ces deux inconvénients conduisent à une hausse des coûts pour le premier aspect et une perte d'efficacité pour le deuxième aspect.

Un but de la présente invention est de répondre aux inconvénients de l'art antérieur mentionnés ci-dessus et en particulier, tout d'abord, de proposer une cellule photovoltaïque permettant une augmentation de la surface utile sur le panneau solaire sans remettre en cause les moyens de production actuels, et sans diminuer l'efficacité à cause d'une augmentation des pertes par effet joule.

Pour cela un premier aspect de l'invention concerne une cellule photovoltaïque comprenant au moins une plaque en matériau actif photovoltaïque de forme rectangulaire avec une largeur et une longueur, la plaque comportant deux faces principales, au moins un collecteur conducteur de l'électricité étant agencé sur chaque face, dans le sens de la largeur de la plaque, **caractérisée en ce que** la largeur de la plaque est supérieure à 151 mm et en ce que la longueur de la plaque est le double de la largeur. Une telle mise en oeuvre permet d'agrandir la surface unitaire de chaque cellule de sorte que le panneau solaire comptera moins de surface perdue entre les cellules. De plus, le choix de produire en série une cellule rectangulaire dont la largeur est supérieure à 151 mm permet de choisir un standard actuel de fabrication de cellules carrées, et l'invention procure l'effet supplémentaire de ne pas nécessiter de changer les équipements de production car tous les manipulateurs et convoyeurs peuvent accueillir des cellules dont une des dimensions est celle d'une standard. En conséquence, la plage de longueur (le double de la largeur, à ±2mm) sera étroite et éloignée de la gamme actuelle qui va jusqu'à 210 millimètres environ. Enfin, en synergie avec les aspects précédents, les pertes dues aux dissipations thermiques provoquées par l'effet joule dans cette mise en oeuvre, malgré l'augmentation de la taille de la cellule, ne sont pas supérieures à celle d'une cellule carrée deux fois moins grande, car les collecteurs sont agencés dans le sens de la largeur. Enfin, on observe un gain au niveau du panneau car les plots de liaison électriques entre les plaques présentent une faible résistance électrique comparativement à celle des collecteurs.

De manière avantageuse, la largeur de la plaque est comprise entre 155 et 157 mm et la longueur de la plaque est comprise entre 311 et 313 mm.

Alternativement, la largeur de la plaque est comprise entre 199 et 201 mm et la longueur de la plaque est comprise entre 399 et 401 mm.

Alternativement, la largeur de la plaque est comprise entre 209 et 211 mm et la longueur de la plaque est comprise entre 419 et 421 mm

L'invention, basée sur les standards de cellules carrées les plus grandes, permet de gagner en efficacité de fabrication, pour produire un panneau avec une surface utile plus importante, sans augmenter les pertes électriques.

Avantageusement, le matériau actif photovoltaïque est du silicium poly-cristallin ou monocristallin. La fabrication de cellule en silicium mono ou poly-cristallin se fait par sciage de lingots de silicium. L'association de la forme rectangulaire avec ces matières permet avantageusement de continuer à utiliser les mêmes lingots, mais de réduire par deux le nombre de traits de scie, car au lieu de scier des parallélépipèdes ayant deux dimensions identiques, le procédé de sciage utilisera des parallélépipèdes dont l'une des dimensions est le double de l'autre.

Avantageusement, l'une des faces principales de la plaque est une face d'exposition destinée à être exposée à un rayonnement lumineux, et elle comporte au moins trois collecteurs conducteurs de l'électricité agencés dans le sens de la largeur de la plaque et chaque collecteur conducteur de l'électricité est relié à des doigts conducteurs de l'électricité agencés sur la face d'exposition, dans le sens de la longueur de la plaque, l'autre face principale de la plaque est une face inférieure, et elle est recouverte d'un matériau conducteur de l'électricité relié au dit au moins un collecteur conducteur de l'électricité agencé sur la face inférieure. Cette mise en oeuvre permet de réduire les pertes par dissipation dans les doigts recouvrant la face d'exposition et la conductivité électrique est optimale avec une feuille recouvrant la face arrière de la cellule.

Avantageusement, la face d'exposition et la face inférieure comportent un nombre identique de collecteurs conducteurs de l'électricité.

Avantageusement, les collecteurs conducteurs de l'électricité de la face d'exposition sont agencés en regard des collecteurs conducteurs de l'électricité de la face inférieure. La connexion lors de l'assemblage sur un panneau solaire est facilitée car les cellules reliées en série sont positionnées côte à côte et les collecteurs de la face inférieure d'une cellule sont en regard des collecteurs de la face d'exposition de la cellule adjacente.

Un second aspect de l'invention est un panneau solaire comportant au moins une cellule photovoltaïque selon le premier aspect de l'invention.

D'autres caractéristiques et avantages de la présente invention apparaîtront plus clairement à la lecture de la description détaillée qui suit d'un mode de réalisation de l'invention donné à titre d'exemple nullement limitatif et illustré par les dessins annexés, dans lesquels :
- la figure 1 représente une vue en élévation d'une cellule photovoltaïque selon l'invention ;
- la figure 2 représente une vue de face de la cellule représentée en figure 1 ;
- la figure 3 représente une vue de côté de cellules selon l'invention reliées en série sur un panneau solaire.

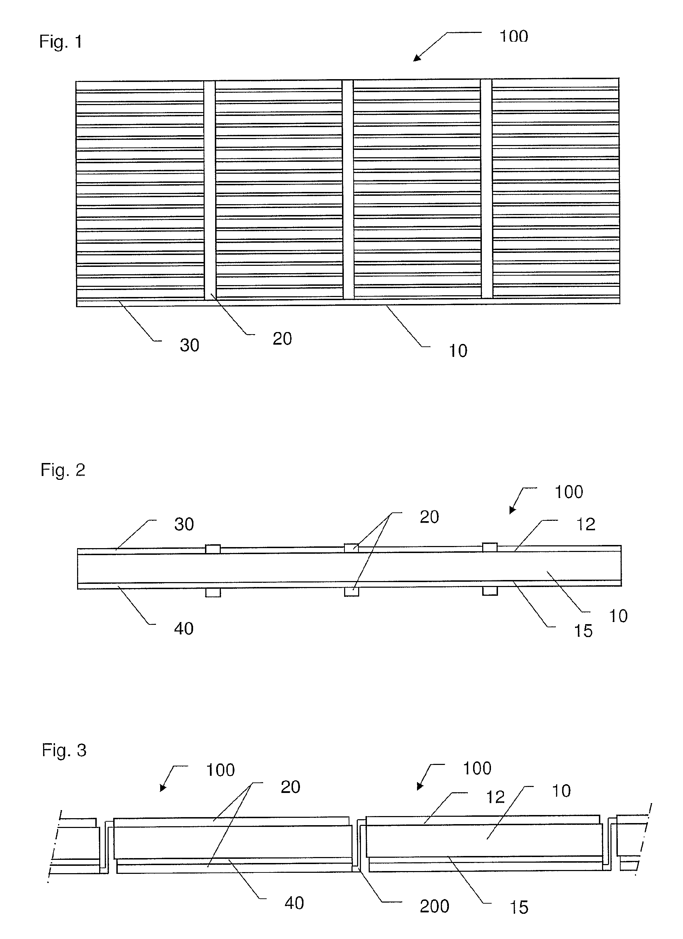

La figure 1 représente une cellule photovoltaïque rectangulaire 100 selon l'invention. La largeur est de 156 millimètres et la longueur est de 312 millimètres. Trois collecteurs électriques 20 sont agencés sur la face supérieure de la cellule 100 dans le sens de la largeur et ils sont reliés à des doigts 30 conduisant l'électricité produite sur la surface de la cellule aux collecteurs 20. LA surface de cette cellule 100 est le double de la surface d'une cellule usuelle carrée de 156 mm x 156 mm, mais le schéma électrique associé à la forme rectangulaire de la cellule 100 permet de garantir que les pertes électriques ne seront pas plus importantes.

La figure 2 représente la tranche vue de face dans le sens de la longueur de la cellule 100. La plaque de matériau actif photovoltaïque 10 comporte une face d'exposition 12 et une face inférieure 15. Les collecteurs 20 sont directement posés sur la face d'exposition 12, ainsi que les doigts 30, afin de conduire correctement l'électricité produite par la cellule 100. La face inférieure 15 est quant à elle recouverte par un matériau conducteur 40 qui conduit l'électricité vers les collecteurs 20.

La figure 3 représente plusieurs cellules 100 vues de côté, dans le sens de la largeur et interconnectées entre elles pour constituer un panneau solaire. Les cellules sont connectées en série par des connecteurs 200 reliant les collecteurs 20 de chaque face inférieure aux collecteurs 20 de chaque face d'exposition de la cellule 100 adjacente. Comme le nombre de collecteurs 20 est identique entre la face d'exposition 12 et la face inférieure 15 de chaque cellule, la connexion est simplifiée car les connecteurs 200 assure le contact électrique de collecteurs 20 en vis-à-vis.

On comprendra que diverses modifications et/ou améliorations évidentes pour l'homme du métier peuvent être apportées aux différents modes de réalisation de l'invention décrits dans la présente description sans sortir du cadre de l'invention défini par les revendications annexées.

## Revendications

1. Cellule photovoltaïque (100) comprenant au moins une plaque (10) en matériau actif photovoltaïque de forme rectangulaire avec une largeur et une longueur, la plaque comportant deux faces principales (12, 15), au moins un collecteur conducteur de l'électricité (20) étant agencé sur chaque face, dans le sens de la largeur de la plaque, **caractérisée en ce que** la largeur de la plaque est supérieure à 151 mm et **en ce que** la longueur de la plaque (10) est le double de la largeur.

2. Cellule photovoltaïque (100) selon la revendication 1, **caractérisée en ce que** la largeur de la plaque (10) est comprise entre 155 et 157 mm et **en ce que** la longueur de la plaque (10) est comprise entre 311 et 313 mm.

3. Cellule photovoltaïque (100) selon la revendication 1, **caractérisée en ce que** la largeur de la plaque (10) est comprise entre 199 et 201 mm et **en ce que** la longueur de la plaque (10) est comprise entre 399 et 401 mm.

4. Cellule photovoltaïque (100) selon la revendication 1, **caractérisée en ce que** la largeur de la plaque (10) est comprise entre 209 et 211 mm et **en ce que** la longueur de la plaque (10) est comprise entre 419 et 421 mm.

5. Cellule photovoltaïque (100) selon l'une des revendications 1 à 4, **caractérisée en ce que** le matériau actif photovoltaïque est du silicium poly-cristallin ou monocristallin.

6. Cellule photovoltaïque (100) selon l'une des revendications 1 à 5, **caractérisée en ce que** l'une des faces principales de la plaque (10) est une face d'exposition (12) destinée à être exposée à un rayonnement lumineux, **en ce qu'**elle comporte au moins trois collecteurs conducteurs de l'électricité (20) agencés dans le sens de la largeur de la plaque, **en ce que** chaque collecteur conducteur de l'électricité (20) est relié à des doigts conducteurs de l'électricité (30) agencés sur la face d'exposition, dans le sens de la longueur de la plaque (10), **en ce que** l'autre face principale de la plaque (10) est une face inférieure (15), et **en ce qu'**elle est recouverte d'un matériau conducteur de l'électricité (40) relié au dit au moins un collecteur conducteur de l'électricité (20) agencé sur la face inférieure (15).

7. Cellule photovoltaïque (100) selon la revendication 6, **caractérisée en ce que** la face d'exposition et la face inférieure comportent un nombre identique de collecteurs conducteurs de l'électricité (20).

8. Cellule photovoltaïque (100) selon la revendication 7, **caractérisée en ce que** les collecteurs conducteurs de l'électricité (20) de la face d'exposition sont agencés en regard des collecteurs conducteurs de l'électricité (20) de la face inférieure.

9. Panneau solaire comportant au moins une cellule photovoltaïque (100) selon l'une des revendications 1 à 8.
